# EUROPÄISCHE PATENTSCHRIFT

(11) **EP 2 183 726 B1**
(45) Veröffentlichungstag und Bekanntmachung des Hinweises auf die Patenterteilung: **04.06.2014**
(21) Anmeldenummer: 08761260.2
(22) Anmeldetag: 20.06.2008
(51) Int. Cl.: G06F 7/58, H03K 3/84, G07C 15/00

(54) **VORRICHTUNG UND VERFAHREN ZUM ERZEUGEN EINER ZUFALLSBITFOLGE**
DEVICE AND METHOD FOR GENERATING A RANDOM BIT SEQUENCE
DISPOSITIF ET PROCÉDÉ POUR PRODUIRE UNE SÉQUENCE BINAIRE ALÉATOIRE

(30) Priorität: 27.08.2007 DE 102007040343
(43) Veröffentlichungstag der Anmeldung: 12.05.2010
(73) Patentinhaber: Siemens Aktiengesellschaft, 80333 München (DE)
(72) Erfinder: DICHTL, Markus, 80636 München (DE)
(86) Internationale Anmeldenummer: PCT/EP2008/057846
(87) Internationale Veröffentlichungsnummer: WO 2009/027130

(56) Entgegenhaltungen:
- EP-A- 1 803 060
- DE-B3- 10 357 782
- US-A1- 2002 120 898
- US-A1- 2004 107 230

## Beschreibung

Die vorliegende Erfindung betrifft Vorrichtungen und Verfahren zum Erzeugen von Zufallsbits und Zufallsbitfolgen. Dies dient beispielsweise zur Implementierung eines Zufallszahlengenerators.

Zufallszahlen, welche in digitaler Form als Zufallsbitfolgen auftreten, werden häufig in sicherheitsrelevanten Anwendungen benötigt. Es ist beispielsweise bei asymmetrischen Authentifikationsverfahren notwendig, Zufallszahlen zu erzeugen und zu verwenden. Insbesondere bei immer häufiger anzutreffenden RFID-Tags sind entsprechende Zufallszahlen mit besonders niedrigem Hardwareaufwand zu generieren. Wünschenswert ist es dabei, lediglich digitale Logikschaltungen, welche aufwandsgünstig implementiert werden können, einzusetzen.

In der Vergangenheit wurden Zufallszahlengeneratoren z. B. unter Verwendung analoger Rauschquellen, deren Signale digitalisiert werden, verwendet. Hybride Analog/Digital-Schaltungen sind jedoch nur aufwändig zu implementieren.

Ein Zufallszahlengenerator, der praktisch ausschließlich digitale Logikschaltungen aufweist, ist in der WO 2006/015624 A1 beschrieben. In dieser internationalen Patentanmeldung wird vorgeschlagen, zufällige Phasenschwankungen von aus digitalen Gattern aufgebauten Ringoszillatoren zu verwenden. Gemäß der W0 2006/015624 A1 eignen sich jedoch lediglich sehr spezielle Ringoszillatoren, nämlich Fibonacci- oder Galois-Ringoszillatoren mit besonderen Eigenschaften zum Einsatz in einen Zufallszahlengenerator. Bei einem derart aufgebauten Schaltkreis wird davon ausgegangen, dass die Ringoszillatoren keine Fixpunkte aufweisen dürfen. Diese Bedingung kann insbesondere für Fibonacci- oder Galois-Oszillatorschaltkreise durch mathematische Gleichungen dargestellt werden, die gemäß der W0 2006/015624 A1 erfüllt sein müssen. Bei einer entsprechenden Implementierung ist daher zunächst zu prüfen, ob ein Ringoszillator Fixpunkte aufweist. Nachteilig ist damit die Auswahl von in Frage kommenden Oszillatorschaltkreisen sehr eingeschränkt.

Die EP 1 803 060 A offenbart eine integrierte Schaltung mit Zufallszahlengeneratoren. Dabei ist vorgesehen, in Abhängigkeit von einem echten physikalischen Zufallszahlengenerator Zufallsbitfolgen abzuleiten. Unter einem echten Zufallszahlengenerator wird ein instabiles physikalisches System verstanden, welches nicht reproduzierbare physikalische Effekte aufweist. Als Beispiel wird die Impedanz eines porösen elektrischen Materials, der Widerstand eines lichtempfindlichen Halbleitermaterials und ein temperaturabhängiger Widerstand eines Metalls genannt. Dieses instabile physikalische System wird in einen Ringoszillatorschaltkreis eingefügt

Es ist daher eine Aufgabe der vorliegenden Erfindung, eine verbesserte Vorrichtung zum Erzeugen von Zufallsbits zu schaffen.

Diese Aufgabe wird durch eine Vorrichtung mit den Merkmalen des Patentanspruchs 1 gelöst.

Demgemäß weist eine Vorrichtung zum Erzeugen einer Zufallsbitfolge einen digitalen Ringoszillatorschaltkreis mit logischen Bauelementen auf, wobei die logischen Bauelemente eine ungerade Anzahl kaskadiert verschalteter Inverter oder eine ungerade Anzahl kaskadiert verschalteter Logikschaltungen aufweist. Der Ringoszillatorschaltkreis hat einen Eingangsknoten und einen Ausgangsknoten und ist derart ausgestaltet, dass bei einem Zustandswechsel eines an dem Eingangsknoten gekoppelten logischen Startsignals eine Oszillation einsetzt. Die Oszillation kann einen Fixpunkt erreichen, wobei bis zum Erreichen des Fixpunkts an dem Ausgangsknoten des Ringoszillatorschaltkreises ein Zufallssignal mit einem zufälligen Pegelverlauf abgreifbar ist.

Unter einem Fixpunkt wird im Folgenden verstanden, dass die logischen Bauelemente des Ringoszillatorschaltkreises einen stabilen logischen Zustand einnehmen. Dieser muss nicht zwingend während des Betriebs der Vorrichtung zum Erzeugen einer Zufallszahlenfolge eingenommen werden. Der Ringoszillatorschaltkreis ist jedoch derart ausgestaltet, dass ein stabiler Fixpunkt grundsätzlich existiert. Das Vorliegen eines entsprechenden Fixpunktes kann zum Beispiel mathematisch bestimmt werden. Vorzugsweise handelt es sich um wohldefinierte logische Zustände der Bauelemente und nicht metastabile Zustände, wobei zwar keine Oszillation des Ringoszillators auftritt, die jeweiligen internen Potenziale jedoch auf einem Pegel verharren, der zwischen den den logischen Pegeln zugeordneten Potenzialen liegt.

Durch thermische oder quantenmechanische Vorgänge innerhalb der zur Implementierung des Oszillators verwendeten Halbleiterbauelemente entstehen zum Beispiel Phasenschwankungen oder Jitter, welche zufällige interne Signal- oder Potenzialverläufe hervorrufen. Die logischen Bauelemente, beispielsweise eine ungerade Anzahl von Inverterschaltungen, können z. B. zum Ausbilden eines Ringoszillators kaskadenförmig zu einem Ring gekoppelt sein, wobei durch die ungerade Anzahl der Inverterschaltungen eine Oszillation möglich wird. In der Regel hängt die Oszillationsfrequenz von der Anzahl der verwendeten Inverter- oder Logikschaltungen ab. Durch unterschiedlich auftretende Verzögerungen bei der Signalverarbeitung durch die einzelnen logischen Bauelemente stellt sich in der Regel keine konstante Phase sondern ein Jitter ein.

Bei der vorliegenden Erfindung wird davon ausgegangen, dass das Erreichen eines Fixpunktes des Ringoszillatorschaltkreises unschädlich für den zumindest in der Anfangszeit der Oszillation auftretenden zufälligen Jitters ist. Jeder Ringoszillatorschaltkreis weist in seinem Signalverlauf nach dessen Aktivierung bzw. Starten zufällige zeitliche Pegelverläufe auf. Diese werden berücksichtigt, um z. B. den logischen Pegel eines Zufallsbits zu bestimmen.

Die Vorrichtung zum Erzeugen einer Zufallsbitfolge hat insbesondere den Vorteil, dass sie einfach zu implementieren ist und Berechnungen, wie sie beispielsweise beim Stand der Technik zum Ausschließen eines Fixpunktes notwendig sind, nicht durchgeführt werden müssen. Als Ringoszillatorschaltkreise kommt damit eine größere Klasse von Oszillatoren in Frage. Dabei können selbstverständlich auch Galois- oder Fibonacci-Ringoszillatoren eingesetzt werden. Ferner haben Ringoszillatoren mit Fixpunkten den Vorteil, dass bei Erreichen des Fixpunktes, was bei der vorgeschlagenen Vorrichtung zum Erzeugen einer Zufallsbitfolge für die Güte der Zufälligkeit unschädlich ist, der Energieverbrauch stark zurückgeht. Dies trifft insbesondere bei einer Implementierung der entsprechenden Schaltungsanordnungen in CMOS-Technologie zu.

Durch die besonders aufwandsgünstige Implementierung, die vorzugsweise ausschließlich digitale Bauelemente aufweist, ist eine Realisierung in der Art einer FPGA-Schaltung besonders günstig. Unter einem FPGA versteht man programmierbare integrierte Schaltkreise in der Digitaltechnik. FPGAs können durch eine Konfiguration interner Strukturen, die logische Gatter bilden können, "im Feld" programmiert werden (FPGA = Field Programable Gate Array). Selbstverständlich kann die entsprechende Vorrichtung zum Erzeugen von Zufallszahlen auch als anwendungsspezifische integrierte Schaltung (ASIC = Application Specific Integrated Circuit) ausgeführt werden, zum Beispiel in CMOS.

In einer Ausführungsform der Vorrichtung ist ein an den Ausgangsknoten gekoppeltes Zwischenspeicherelement vorgesehen, welches in Abhängigkeit von dem Zufallssignal einen logischen Pegel speichert.

Es ist z. B. möglich, ein Zwischenspeicherelement als Flip-Flop auszubilden, welches beim Durchlaufen eines vorbestimmbaren logischen Schwellwertes seinen internen abgespeicherten Zustand wechselt. Bekannte Flip-Flops wechseln zum Beispiel den intern abgespeicherten logischen Zustand bei jeder steigenden oder fallenden Signalflanke des eingekoppelten Zufallssignals. Das heißt, sofern das Zufallssignal zwischen zwei logischen Pegeln unregelmäßig schwankt, liefert das Zwischenspeicherelement einen Zufallsbitwert, der von der nicht bestimmbaren Anzahl von beispielsweise steigenden oder fallenden Flanken des Zufallssignals abhängt. Beispielsweise kann das Zwischenspeicherelement einen dem Zufallssignal entsprechenden logischen Pegel speichern.

Es ist dabei denkbar, dass das Zwischenspeicherelement, wie beispielsweise ein Flip-Flop, in Abhängigkeit von einem Abtastsignal einen dem Zufallssignal entsprechenden logischen Pegel speichert. Ein Abtastsignal, beispielsweise ein externes Taktsignal, führt dazu, dass zu bestimmten Zeitpunkten der Pegel des Zufallssignals von dem Zwischenspeicherelement erfasst wird und entweder als Zufallsbit verwendet wird oder auch ein Invertieren des gespeicherten logischen Pegels im Zwischenspeicherelement hervorruft.

Durch regelmäßiges Abtasten, beispielsweise mit einem D-Flip-Flop, des Zufallssignals, insbesondere in einem Zeitraum bevor der Ringoszillator potenziell einen stabilen Fixpunkt erreicht, ist der zufällige Pegelverlauf des Zufallssignals ausreichend, um eine zufällige Verteilung der erfassten Zufallsbits zu erzielen.

Die Abtastsignalerzeugungseinrichtung ist vorzugsweise derart ausgestaltet, dass das Abtastsignal innerhalb eines vorgegebenen Zeitraums mehrere Zustandswechsel aufweist. Der vorgegebene Zeitraum entspricht zum Beispiel einem durchschnittlicher Oszillationszeitraum. Der Fixpunkt tritt üblicherweise nach einem vorhergehenden Oszillationszeitraum auf. Es kann zum Beispiel die Verteilung dieser Oszillationszeiträume eines Ringoszillators durch Messungen bestimmt werden. Der vorgegebene Zeitraum ist vorzugsweise so gewählt, dass ein substanzieller Anteil der Schwingungen innerhalb des Zeitraums auftritt.

Eine Abtastsignalerzeugungseinrichtung erzeugt gemäß einer Ausführungsform mehrere Zustandswechsel für ein Abtastsignal, sodass innerhalb der durchschnittlichen Oszillationszeit das Zufallssignal an dem Ausgangsknoten mehrfach erfasst wird. Vorzugsweise wird der Ringoszillatorschaltkreis derart eingestellt, dass dieser nicht von einem Fixpunkt aus aktiviert wird und somit während der durchschnittlichen Oszillationszeit zeitlich nicht vorhersehbare, also randomisierte, Pegelverläufe zeigt. Zufallsbits können damit durch periodisches Sampeln oder Abtasten des Zufallssignals bestimmt werden.

Ein entsprechendes Startsignal zum Neustarten des Ringoszillators kann z. B. von einer Rechtecksignalerzeugungseinrichtung geliefert werden, welche ein Startsignal mit wechselnden logischen Pegeln erzeugt. Insofern wird der eingesetzte Ringoszillatorschaltkreis regelmäßig neu gestartet, sodass die Gefahr des Einschwingens in einen Fixpunkt reduziert wird.

In einer bevorzugten Ausführungsform der Vorrichtung ist eine Steuerungseinrichtung vorgesehen, welche z. B. gemäß einer Programmierung ein Abgreifen eines Zufallsbitwertes an dem Ausgangsknoten oder Zwischenspeicherelement und/oder die Erzeugung des Startsignals veranlasst. Es ist damit eine Realisierung einer Ansteuerungsschaltung denkbar, die die Erzeugung eines einzelnen Zufallsbit immer von einem selben Startzustand des Ringoszillators beginnen lässt. Bei einem Rücksetzen oder Neustart bzw. Wiederaktivieren des Ringoszillators von diesem Startzustand und die Erzeugung eines weiteren Zufallsbit kann vorzugsweise eine Wartezeit legen, damit der Ringoszillatorschaltkreis relaxieren oder abklingen kann.

Die Erzeugung einer Zufallsbitfolge kann insbesondere durch Invertieren eines an den Ausgangsknoten angeschlossenen Flip-Flops bei jedem 0-1-Durchgang des Zufallssignals erfolgen, wobei die Zufallsbits auch durch periodisches Sampeln oder Abtasten des zwischengespeicherten logischen Pegels dieses Flip-Flops bestimmbar ist. Auch wenn der entsprechende Ringoszillator vor dem Abtasten des entsprechenden Zufallsbitwertes an dem Flip-Flop in einem Fixpunkt verbleibt, ist dies nicht schädlich für die Zufälligkeit des zwischengespeicherten logischen Pegels bzw. Zufallsbitwertes. Die Zufälligkeit wird dabei z. B. durch die vorher berücksichtigten 0-1-Durchgänge ausreichend berücksichtigt. Ebenso sind andere Merkmale, wie zum Beispiel 1-0-Durchgänge, des Zufallssignals verwendbar.

In einer Weiterbildung der Erfindung ist ein Zufallszahlengenerator mit einer vorbeschriebenen Vorrichtung zum Erzeugen einer Zufallsbitfolge vorgeschlagen. Dabei werden mehrere abgegriffene Pegelwerte des Zufallssignals oder von einem Zwischenspeicherelement gespeicherte logische Pegel als Bitwerte einer Zufallszahl erfasst.

Die Erfindung betrifft ferner ein Verfahren zum Erzeugen einer Zufallsbitfolge gemäß Patentanspruch 16.

Dabei werden Zufallsbitwerte in Abhängigkeit von einem Pegelverlauf eines an einem digitalen Ringoszillatorschaltkreis abgegriffenen Zufallssignals bestimmt. Der digitale Ringoszillatorschaltkreis weist dabei eine ungerade Anzahl kaskadiert verschalteter Inverter oder eine ungerade Anzahl kaskadiert verschalteter Logikschaltungen auf. Durch Aktivieren des Ringoszillatorschaltkreises erfolgt eine Oszillation, wobei der Ringoszillator einen Fixpunkt aufweist, in dem die Inverter oder die Logikschaltungen logische Zustände aufweisen, die sich zeitlich nicht mehr ändern, wobei das Zufallssignal bis zum Erreichen des Fixpunkts mit einem zufälligen Pegelverlauf abgegriffen wird.

Das entsprechende Verfahren kann z. B. durch geeignete Programmierung programmierbarer digitaler Logikschaltungen, wie beispielsweise FPGAs implementiert werden. Ein Aktivieren des Ringoszillatorschaltkreises kann zum Beispiel durch Einschalten oder Ankoppeln einer geeigneten Versorgungsspannung an die entsprechende Schaltungsanordnung erfolgen. Ferner ist ein Aktivieren entsprechend einer jeweiligen Implementierung der Ringoszillatorschaltung durch Ankoppeln eines geeigneten Steuer- oder Startsignals möglich. Unter Aktivieren ist ein Vorgang zu verstehen, der in einer Oszillation des Ringoszillatorschaltkreises, vorzugsweise ausgehend von einem vorgegebenen Startzustand der eingesetzten Logikgatter, resultiert.

In einer Variante der Verfahrens werden dabei die folgenden Verfahrensschritte durchgeführt: Aktivieren eines digitalen Ringoszillatorschaltkreises, der einen Fixpunkt aufweist, und Abgreifen eines oder mehrerer Pegelwerte eines von dem Ringoszillatorschaltkreis erzeugten oszillierenden Zufallssignals.

Dabei kann der Ringoszillatorschaltkreis zum Erzeugen mehrerer Zufallsbitwerte mehrfach aktiviert werden. Insofern werden Situationen, in denen der Ringoszillator bereits seinen Fixpunkt erreicht zwar für die Zufallsbitfolgenerzeugung berücksichtigt, jedoch wird durch den (regelmäßigen) Neustart des Schaltkreises der Einfluss auf die Zufälligkeit reduziert.

Wie bereits hinsichtlich der Vorrichtung zum Erzeugen einer Zufallsbitfolge erläutert wurde, kann das Zufallssignal mehrfach abgetastet werden und in Abhängigkeit von einem jeweiligen Pegelwert des Zufallssignals ein logischer Pegel eines Zufallsbits verändert werden. Dies kann beispielsweise durch ein Zwischenspeicherelement wie zuvor beschrieben wurde erzielt werden.

In einer weiteren Variante des Verfahrens wird zunächst eine durchschnittliche Oszillationszeit des Ringoszillatorschaltkreises, z. B. experimentell, bestimmt. Anhand dieser durchschnittlichen Oszillationszeit, in der wahrscheinlich kein Fixpunkt des Oszillators eintritt, kann dann der Pegel des Zufallssignals mehrfach erfasst werden. Insofern wird mittels dem Verfahren zuverlässig eine Zufallsbitfolge erfasst obwohl gegenüber der weit verbreiteten Annahme, fixpunktbehaftete Oszillatoren seien für die Zufallszahlengenerierung unbrauchbar, ein eben solcher verwendet wird.

Weitere vorteilhafte Ausgestaltungen der Erfindung sind Gegenstand der Unteransprüche sowie der im Folgenden beschriebenen Ausführungsbeispiele.

Im Folgenden wird die Erfindung unter Bezugnahme auf die beigelegten Figuren und anhand einiger Ausführungsbeispiele näher erläutert. Es zeigt dabei:
- Fig. 1: ein Ausführungsbeispiel eines Zufallszahlengenerators;
- Fig. 2: eine erste Ausführungsform eines Ringoszillatorschaltkreises;
- Fig. 3: eine zweite Ausführungsform eines Ringoszillatorschaltkreises;
- Fig. 4: eine kumulative Verteilung von minimalen Oszillationszeiten eines Ringoszillatorschaltkreises;
- Fig. 5: beispielhafte Zufallssignalpegelverläufe eines Ringoszillatorschaltkreises; und
- Fig. 6: ein prinzipielles Ablaufdiagramm für ein Verfahren zum Erzeugen von Zufallsbitfolgen.

In den Figuren sind gleiche oder funktionsgleiche Elemente mit denselben Bezugszeichen versehen worden, sofern nichts anderes angegeben ist.

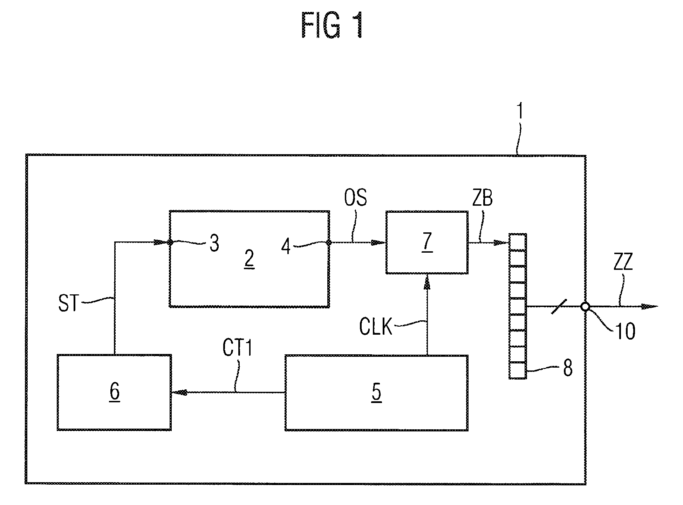

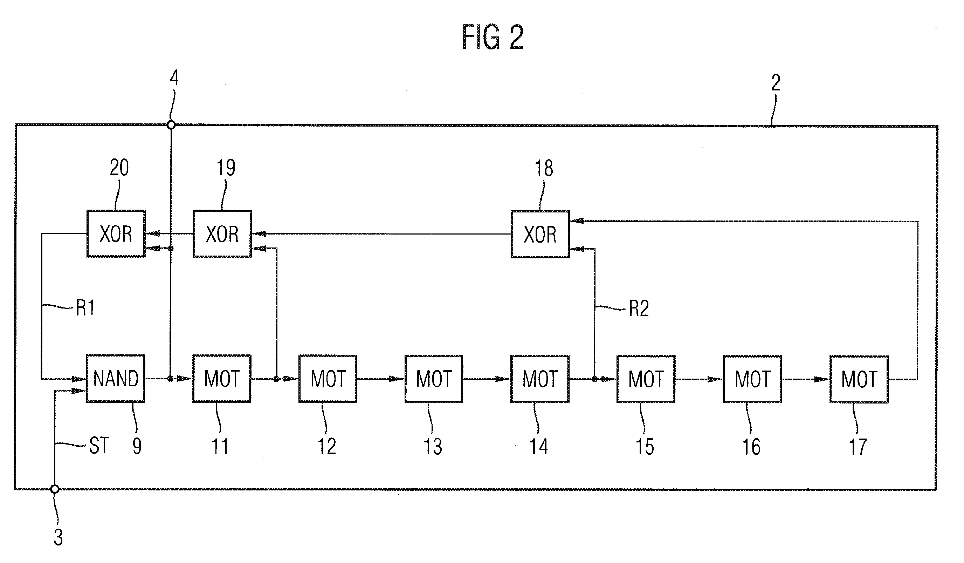

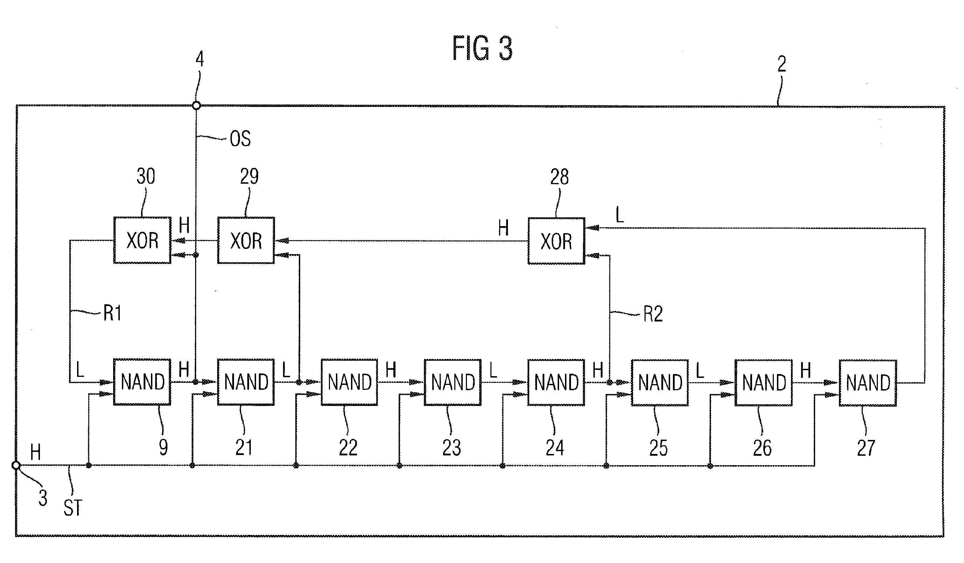

In der Fig. 1 ist beispielhaft ein Zufallszahlengenerator 1 dargestellt. Der Zufallszahlengenerator 1 weist einen Ringoszillatorschaltkreis 2 mit einem Eingangsknoten 3 und einem Ausgangsknoten 4 auf. Ausführungsbeispiele für Ringoszillatoren sind z. B. in den folgenden Fig. 2 und 3 näher erläutert.

Beispielsweise kann ein Ringoszillator durch kaskadierte Verschaltung mehrerer Inverter realisiert werden. Inverter oder auch andere logische Bauelemente dienen dabei als Verzögerungselemente, wobei nicht vorhersagbare Schwankungen der einzelnen Verzögerungszeiten nicht vorhersagbare Oszillationsvariationen, sogenannte Jitter, hervorrufen. Die Verzögerungsschwankungen beruhen in der Regel auf verschiedenen internen und externen Rauschfaktoren, wie beispielsweise die Hardwareimplementierung der Bauelemente und Strom-, Spannungs- und/oder Temperaturschwankungen. Sofern, wie es bei Inverter oder logischen Gattern der Fall ist, die Verzögerungszeit extrem kurz ist, liefern diese nichtvorhersagbaren Fluktuationen zufällige Pegelverläufe des prinzipiell oszillierenden Signals, welches an dem Ausgangsknoten 4 als Zufallssignal OS abgreifbar ist.

Der Ringoszillatorschaltkreis 2 lässt sich durch ein geeignetes Startsignal ST, welches dem Eingangsknoten 3 eingekoppelt ist, aktivieren bzw. starten. Es wird dabei angenommen, dass der Ringoszillatorschaltkreis 2 einen Fixpunkt aufweist, d. h. stabile Zustände existieren, in denen die logischen Bauelemente logische Zustände aufweisen, die sich zeitlich nicht mehr ändern. Bis zum Erreichen eines derartigen Fixpunktes erfolgt jedoch eine praktisch zufällige Veränderung der entsprechenden abgreifbaren Pegel.

Das Zufallssignal OS ist einem Zwischenspeicherelement 7, z. B. einer Flip-Flop-Einrichtung, zugeführt. Die Flip-Flop-Einrichtung 7, beispielsweise ein D-Flip-Flop, nimmt an einem Dateneingang das Zufallssignal an und liefert an einem Datenausgang einen zwischengespeicherten logischen Pegel als Zufallsbit ZB. Da das Zufallssignal OS zeitlich fluktuiert und zufällig schwankt, ist z. B. denkbar, dass durch Einkoppeln eines Abtastsignals, beispielsweise in der Form eines Taktsignals CLK, an einen Takteingang des Flip-Flop 7, der zum Abtastzeitpunkt also z. B. beim Vorliegen einer steigenden oder fallenden Taktflanke, gegenwärtige Wert des Zufallssignals OS erfasst bzw. zwischenspeichert wird.

Ein entsprechendes Abtast- oder Taktsignal CLK wird in der beispielhaften Darstellung der Fig. 1 durch eine Steuereinrichtung 5 geliefert. Die Steuereinrichtung 5 erzeugt ebenfalls geeignete Steuersignale CT1, um einen Rechtecksignalgenerator 6, der das Startsignal ST an den Eingangsknoten 3 des Ringoszillators 2 liefert, zu steuern.

Es sind verschiedene Ausführungsbetriebsmodi des Zufallszahlengenerators 1 denkbar. Zum Beispiel kann, wie zuvor beschrieben wurde, zu jedem Abtastzeitpunkt das Zufallssignal OS durch das Zwischenspeicherelement 7 erfasst werden und als ein Zufallsbit ZB ausgegeben werden. Dies wird beispielsweise in ein Schieberegister 8 eingeführt. Nach einer vorgegebenen Anzahl von Abtastzeitpunkten liegt damit eine Zufallsbitfolge in dem Schieberegister 8 vor. Alternativ kann, auch wenn es in der Fig. 1 nicht explizit dargestellt ist, auch das Schieberegister durch das Taktsignal CLK angesteuert werden. An einem Ausgang 10 des Zufallszahlengenerators 1 ist dann eine binär kodierte Zufallszahl ZZ abgreifbar.

Alternativ kann das Zwischenspeicherelement oder Flip-Flop 7 auch derart ausgestaltet sein, dass bei jedem 0-1- oder auch 1-0-Durchgang des Zufallssignals OS der intern gespeicherte Wert des Zufallsbits ZB im Zwischenspeicherelement 7 geändert wird. Damit wird als zusätzliches zufälliges Element die Anzahl der Schwankungen oder Oszillationen des Zufallssignals OS zur Erzeugung eines Zufallsbits verwendet. In Abhängigkeit von dem Abtast- oder Taktsignal CLK wird dann der zufällig erzeugte Pegelzustand im Zwischenspeicherelement als Zufallsbit ZB ausgegeben.

Es ist weiterhin denkbar, vor jeder Zufallsbiterzeugung den Ringoszillatorschaltkreis 2 zurückzusetzen bzw. erneut zu starten, um die Gefahr des Erreichens eines Fixpunktes zu reduzieren. Vorzugsweise wird bei dem Rücksetzen oder Initialisieren des Ringoszillatorschaltkreises vorgegeben, dass der Startzustand, also die logischen Pegel aller logischen und digitalen Bauelemente, welche in dem Ringoszillatorschaltkreis 2 verwendet werden, nicht dem eines Fixpunktzustandes entsprechen.

Im Folgenden sind beispielhafte prinzipiell Fixpunkte aufweisende Ringoszillatorschaltkreise, welche sich zum Einsatz in einer Vorrichtung zur Erzeugung von Zufallsbitfolgen eignen, näher erläutert.

In der Fig. 2 ist ein Ringoszillatorschaltkreis 2 dargestellt. Dabei ist eine Verzögerungsstrecke aus sieben Invertern 11 - 17 aufgebaut, dem ein NAND-Gatter vorgeschaltet ist. Die Inverter sind dabei in der Schaltung als NAND-Gatter angegeben. Das NAND-Gatter 9 erhält als Eingangsgrößen ein Startsignal ST und ein Rückkopplungssignal R1. Das Ausgangssignal des NAND-Gatters 9 ist dabei an einen Ausgangsknoten 4 des Ringoszillatorschaltkreises 2 und als Eingangsgröße einem XOR-Gatter 20 zugeführt, welches ausgangsseitig das Rückkopplungssignal R1 liefert.

Ferner ist das Ausgangssignal des letzten Inverters 17 einem Eingang eines XOR-Gatters 18 zugeführt, wobei ferner ein Rückkopplungssignal R2, welches dem Ausgangssignal des vierten Inverters 14 entspricht, zugeführt ist. Einem weiteren XOR-Gatter 19 sind das Ausgangssignal des ersten Inverters 11 sowie das Ausgangssignal des XOR-Gatters 18 zugeführt. Das das Rückkopplungssignal R1 bildende XOR-Gatter 20 erhält ebenfalls das Ausgangssignal des weiteren XOR-Gatters 19. Insgesamt ergibt sich ein Ringoszillatorschaltkreis, welcher nur elf logische Gatter aufweist und besonders einfach z. B. in RFID-Chips oder -Tags implementierbar ist.

Eine alternative Ausführungsform eines Ringoszillatorschaltkreises ist in der Fig. 3 dargestellt. Dabei ist im Wesentlichen dieselbe Topologie wie in der Fig. 2 verwendet, wobei jedoch die Inverter 11 - 17 durch NAND-Gatter 21 - 27 ersetzt sind. Die den XOR-Gattern 18 - 20 der Fig. 2 entsprechenden XOR-Gatter sind mit den Bezugszeichen 28 - 30 in der Fig. 3 versehen.

Ein logischer Pegel 0 oder Low an dem Eingangsknoten 3, beispielsweise in Form eines entsprechenden Startsignals ST, führt zu einem deterministischen Zustand sowohl der Ringoszillatorschaltung 2 gemäß der Fig. 2 als auch gemäß der Fig. 3. Bei ST=0 schwingt die Oszillatorschaltung nicht. Tritt ein Wechsel von 0 auf 1, also eine steigende logische Flanke, des Startsignals ST auf, beginnt die jeweilige Oszillatorschaltung bzw. der jeweilige Ringoszillator 2 eine Oszillation.

Diese Oszillation dauert solange an, bis ein stabiler Zustand der jeweiligen Schaltungsanordnung erreicht wird. Dies kann z. B. ein Fixpunkt sein, bei dem die Zustandsbelegung der einzelnen logischen Gatter stabil ist und sich ein erneutes Schwingen nur durch ein erneutes Starten oder Rücksetzen der einzelnen logischen Pegel der Gatter erzwingen lässt. In der Fig. 3 sind beispielhaft an den Ausgängen der jeweiligen Logikgattern 9, 21 - 30 die logische Zustände in einem Fixpunkt H = 1, L = 0 dargestellt. In der Regel stellt sich der Fixpunkt, abgesehen in der Situation, in der bereits beim Start des Ringoszillators 2 der Fixpunkt vorliegt, nach einer Phase mit zufälligen Oszillationen bzw. mit einem zufälligen Pegelverlauf an dem Ausgangsanschluss 4 ein. Es kann z. B. der entsprechende Ringoszillatorschaltkreis 2 zunächst auf seine Fixpunkteigenschaft experimentell untersucht werden.

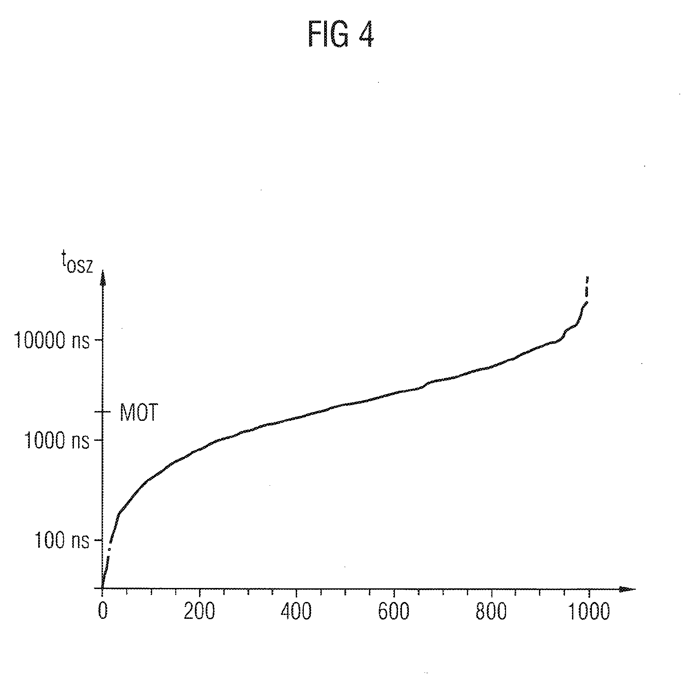

In der Fig. 4 ist für eine Implementierung mit dem Ringoszillator, wie er in der Fig. 3 dargestellt ist, eine kumulative Verteilung für Zeiten, nach denen der Ringoszillator einen Fixpunkt erreicht, aufgetragen. Die in der Fig. 4 dargestellte Statistik stützt sich auf 1.000 Neustarts des Ringoszillators 2, wie er in der Fig. 3 dargestellt ist, wobei auf der Y-Achse die Zeiten nach denen der Fixpunkt erreicht wurde, also ein stabiler logischer H-Pegel am Ausgangsknoten 4 abgegriffen wird, aufgetragen. Die Fig. 4 zeigt die kumulative Verteilung der entsprechenden Zeiten bis zum Erreichen eines Fixpunktes vom Neustart des Ringoszillators bei 1.000 Versuchen. Die vertikale Achse ist dabei logarithmisch aufgetragen.

Es ergibt sich für den in der Fig. 3 dargestellten Ringoszillator ein Median von 2.277 ns und ein Mittelwert (MOT) für die Zeiten zum Erreichen des Fixpunktes nach 3.686 ns. Bei der experimentellen Bestimmung dieser Zeiten bis zum Erreichen des Fixpunktes ergibt sich nur bei 16 von 1.000 Neustarts eine Zeit von weniger als 100 ns nach dem Neustart. Es ist somit trotz des Vorliegens eines Fixpunktes für die in dem Zufallsgenerator verwendeten Ringoszillatoren praktisch ausgeschlossen, dass lediglich dieser Fixpunkt bzw. ein entsprechender logischer Pegel als Zufallsbit erfasst wird. Insbesondere die Berücksichtigung des Pegelverlaufes bis zum Erreichen des Fixpunktes, der zufällig ist, liefert zuverlässige zufällige Bitwerte.

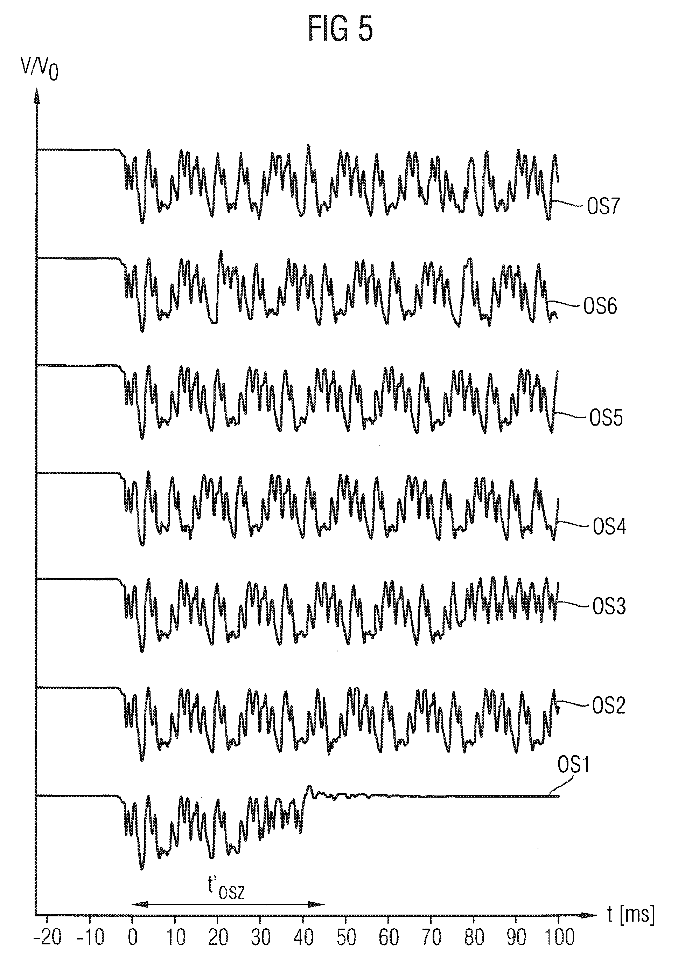

In Fig. 5 sind beispielhaft die Pegelverläufe des Zufallsignals OS, welches am Ausgangsknoten 4 des in der Fig. 3 dargestellten Ringoszillators abgreifbar ist, dargestellt. Auf der X-Achse ist die Zeit in Nanosekunden dargestellt und auf der Y-Achse beispielhafte Pegelverläufe OS1 - OS7, welche auf einen jeweiligen logischen Pegelwert V₀ normiert sind, dargestellt. Dabei sind die verschiedenen Pegelverläufe OS1 - OS7 auf der Y-Achse gegeneinander verschoben dargestellt.

Zum Zeitpunkt t=0 ist der Ringoszillator 2 aktiviert bzw. gestartet worden. Dies erfolgt durch Umschalten des Startsignals ST von logischem L- auf logischen H-Pegel. Die dargestellten Kurven OS1 - OS7 können beispielsweise mit einem Oszilloskop an einem Ausgangsknoten 4 abgegriffen werden.

Beispielsweise zeigt die Kurve OS1 des Pegelverlaufes das Erreichen des Fixpunktes, also einen stabilen H-Pegel am Ausgangsknoten 4 bereits nach etwa 50 ns. Die übrigen beispielhaft ausgewählten Pegelverläufe OS2 - OS7 hingegen zeigen zufällige Oszillationen in diesem Zeitbereich. Sofern beispielsweise durch entsprechende experimentelle Daten festgestellt wird, dass zumindest innerhalb einer minimalen Oszillationszeit t_{OSZ}', die in der Fig. 5 z. B. mit etwa 42 ns angegeben werden kann, der Fixpunkt nicht erreicht wird, ist es ausreichend zur Bestimmung eines Zufallsbits den innerhalb dieser Zeit t_{OSZ}' vorliegenden Pegelverlauf zu berücksichtigen. Dies kann z. B. dadurch erfolgen, dass der Ausgangsknoten 4 der Ringoszillatorschaltung nach Ablauf einer vorgegebenen Zeit nach dem Neustart direkt abgetastet wird. Ferner kann dies, wie in der Fig. 1 schematisch dargestellt ist, über ein Flip-Flop geschehen. Es lassen sich auch andere Zeiträume verwenden, wie zum Beispiel eine mittlere Oszillationszeit MOT oder der Median der Verteilung der Figur 4. Ein substanzieller Anteil der Oszillationen bevor ein Fixpunkt ereicht wird sollte jedoch bei der Zufallsbiterzeugung berücksichtig werden.

Sofern bei direkten Sampeln oder Abtasten immer der Fixpunkt erreicht wird, eignen sich der Ringoszillator sowie die Abtastzeitpunkte nicht zur Erzeugung von Zufallsbits. Falls jedoch der Fixpunkt häufig jedoch nicht immer vor dem Abtasten erreicht wird, erzeugt der Zufallsgenerator bzw. der Ringoszillatorschaltkreis statistisch unabhängige Zufallsbits. Diese Zufallsbits können eine Schiefe aufweisen, d. h. die Wahrscheinlichkeit 0 oder 1 abzugreifen liegt nicht bei 50 %. Durch geeignete algorithmische Nachbearbeitung kann eine derartige Schiefe jedoch für das Erreichen des Fixpunktes kompensiert werden. Es sind zum Beispiel Verfahren bzw. Algorithmen bekannt, die auch ohne Kenntnis der konkreten statistischen Eigenschaften der Zustandsverteilung eine Schiefe kompensieren.

Wird ein Flip-Flop zum Erfassen oder Abtasten des zufälligen Pegelverlaufs, beispielsweise der Signale OS1 - OS7 verwendet, ist eine Implementierung möglich, bei der bei z. B. jeder aufsteigenden Flanke des Signals OS1 - OS7 ein Zustandswechsel im zwischengespeicherten Zustand des Flip-Flops auftritt. Es spielt dann keine Rolle ob beim Auslesen des Zwischenspeicherelementes bzw. Flip-Flops bereits ein Fixpunkt erreicht ist oder nicht.

Es ist auch denkbar, dass bei vorgegebenen Zeitpunkten bzw. Abtastzeitpunkten, die durch ein Taktsignal vorgegeben sein können, ein Zustandswechsel des vom Flip-Flop gespeicherten logischen Pegels in Abhängigkeit von dem jeweiligen vorliegenden Pegel des Zufallssignals erfolgt. Dabei sollte eine Berücksichtigung der Pegel des Zufallssignals z. B. durch Abtasten mehrfach innerhalb des bestimmbaren mittleren Oszillationszeitraums MOT erfolgen.

Um die Eigenschaften der Zufälligkeit bzw. Verbesserung der Schiefe zu erzielen, ist es möglich den Ringoszillator in regelmäßigen Abständen zurückzusetzen und einen vorgegebenen Zeitraum relaxieren zu lassen. Dies ist in der Fig. 5 beispielsweise durch die 20 ns dauernde negative Vorlaufzeit bis zum Start des Ringoszillators angedeutet. Sofern der Ringoszillator selbst wenn er einen Fixpunkt aufweist regelmäßig neu gestartet wird, sind statistische Abhängigkeiten der in Abhängigkeit von dem Zufallssignal erzeugten Zufallsbits unmöglich. Es ist lediglich eine Schiefe d. h. eine Abweichung der Häufigkeit der 1-Bits vom Idealwert von der Wahrscheinlichkeit ½ möglich. Untersuchungen der Anmelderin ergeben jedoch, dass z. B. bei einer Implementierung des Ringoszillators gemäß der Fig. 3 in einem Zufallszahlengenerator eine Wahrscheinlichkeit von 0,4951 für den Bitwert 1 bzw. H auftritt. Dies sind 604.398 von 1.220.703 erzeugten Zufallsbits. Eine ähnliche Untersuchung ergab für den in der Fig. 2 dargestellten Ringoszillatorschaltkreis eine Wahrscheinlichkeit für 1-Bits von 0,4966. Diese geringen Schiefen genügen in der Regel allen Ansprüchen wie auch standardisierten Vorgaben für Zufallszahlengeneratoren.

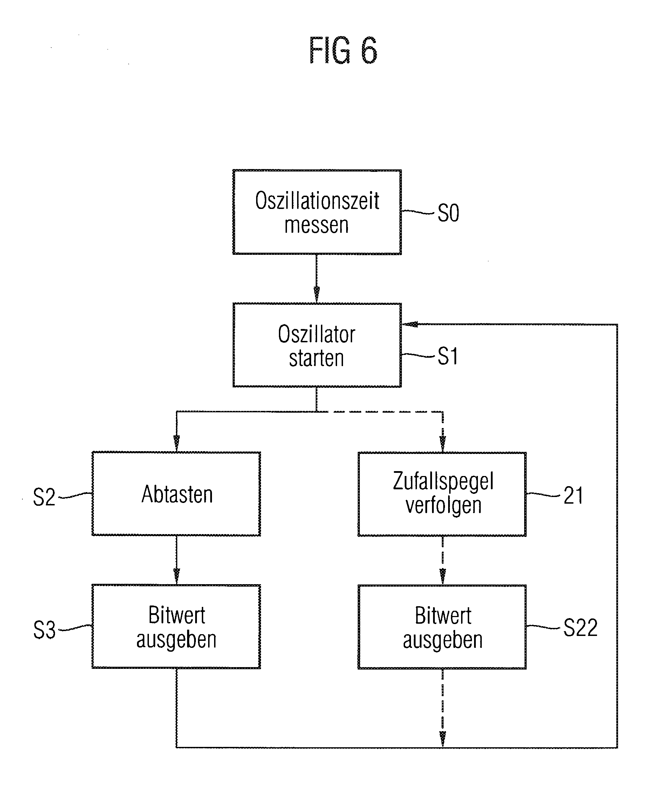

In der Fig. 6 ist abschließend ein beispielhaftes Ablaufdiagramm für ein entsprechendes Verfahren zum Erzeugen von Zufallsbitfolgen dargestellt. Eine Implementierung kann beispielsweise durch geeignete Programmierung von Steuereinrichtungen, wie sie in der Fig. 1 mit dem Bezugszeichen 5 versehen sind, denkbar.

In einem Vorbereitungsschritt S0, der optional durchgeführt wird, kann die Oszillationszeit des verwendeten Ringoszillatorschaltkreises gemessen werden. Als Ergebnis ergibt sich beispielsweise ein mittlerer Oszillationszeitraum, in dem voraussichtlich der Ringoszillator keinen Fixpunkt einnimmt.

Im Schritt S1 wird der Oszillator gestartet. Im Schritt S2 wird das Oszillatorsignal bzw. das Zufallssignal abgetastet, was gemäß dem erfassten Pegel einem logischen 1- oder 0-Pegel entspricht.

Im Schritt S3 wird dann der entsprechende Bitwert ausgegeben. Somit wird ein einzelnes Zufallsbit erzeugt.

Anschließend wird der Oszillator erneut gestartet, so dass weitere Zufallsbits gemäß der Schleife der Schritte S1, S2, S3 erzeugt werden. Die Zufallsbitfolge kann dann z. B. als binärer Code einer Zufallszahl interpretiert werden.

Die Fig. 6 zeigt ferner eine alternative Variante des Verfahrens zum Erzeugen von Zufallsbitfolgen gemäß der Schritt S21 und S22 wobei die Ablaufpfeile gestrichelt dargestellt sind.

Nach dem Start des Ringoszillators S1 werden die Zufallspegel, also der Pegelverlauf des Zufallssignals, welches von dem Ringoszillator erfasst werden kann, im Schritt S21 verfolgt. Ein Verfolgen kann beispielsweise durch regelmäßiges Abtasten oder Einkoppeln des Zufallssignals in eine Zwischenspeichereinrichtung, welche in Abhängigkeit von steigenden oder fallenden Taktflanken einen gespeicherten logischen Pegel ändert, erfolgen. Nach einer beispielsweise vorgegebenen Zeit wird dann der somit zwischengespeicherte Bitwert im Schritt S22 ausgegeben. Durch erneute Abfolge in einer Art einer Programmschleife der Schritte S21, S22 ergeben sich wiederum Zufallsbitfolgen.

Die Erfindung in Form der beispielhaft dargestellten Zufallszahlengeneratoren, Ringoszillatoren und Verfahrensabläufe erreicht eine zuverlässige Erzeugung von Zufallszahlen bei extrem geringem Hardwareaufwand. Die Zufallsbitfolgen oder Zufallszahlen erreichen eine hohe statistische Qualität und können z. B. bei Verschlüsselungsverfahren oder Authentifizierungsalgorithmen, insbesondere auch auf RFID-Chips, eingesetzt werden.

## Patentansprüche

1. Vorrichtung (1) zum Erzeugen einer Zufallsbitfolge mit einem logische Bauelemente aufweisenden digitalen Ringoszillatorschaltkreis (2), welcher einen Eingangsknoten (3) und einen Ausgangsknoten (4) aufweist, wobei der digitale Ringoszillatorschaltkreis (2) derart ausgestaltet ist, dass bei einem Zustandswechsel eines an den Eingangsknoten (3) gekoppelten logischen Startsignals (ST) eine Oszillation erfolgt, **dadurch gekennzeichnet, dass** diese einen Fixpunkt aufweist, in dem die logischen Bauelemente logische Zustände aufweisen, die sich zeitlich nicht mehr ändern, wobei die logischen Bauelemente eine ungerade Anzahl kaskadiert verschalteter Inverter (11-17) oder eine ungerade Anzahl kaskadiert verschalteter Logikschaltungen (21-27) aufweisen, wobei an dem Ausgangsknoten (4) bis zum Erreichen des Fixpunkts ein Zufallssignal (OS) mit einem zufälligen Pegelverlauf abgreifbar ist.

2. Vorrichtung (1) nach Anspruch 1, wobei die Vorrichtung (1) ein an den Ausgangsknoten (4) gekoppeltes Zwischenspeicherelement (7) aufweist, welches in Abhängigkeit von dem Zufallssignal (OS) einen logischen Pegel speichert.

3. Vorrichtung (1) nach Anspruch 2, wobei das Zwischenspeicherelement (1) einen dem Zufallssignal (OS) entsprechenden logischen Pegel speichert.

4. Vorrichtung (1) nach Anspruch 2 oder 3, wobei das Zwischenspeicherelement (7) in Abhängigkeit von einem Abtastsignal (CLK) einen dem Zufallssignal (OS) entsprechenden logischen Pegel speichert.

5. Vorrichtung (1) nach Anspruch 4, wobei die Vorrichtung (1) eine Abtastsignalerzeugungseinrichtung (5) aufweist, welche zu vorgegebenen Zeitpunkten einen logischen Zustandswechsel des Abtastsignals (CLK) erzeugt.

6. Vorrichtung (1) nach Anspruch 4 oder 5, wobei die Abtastsignalerzeugungseinrichtung (7) derart ausgestaltet ist, dass das Abtastsignal (CLK) innerhalb eines vorgegebenen Zeitraums mehrere Zustandswechsel aufweist.

7. Vorrichtung (1) nach einem der Ansprüche 4 - 6, wobei der Fixpunkt nach einem Oszillationszeitraum (t_{OSZ}) auftritt, und die Abtastsignalerzeugungseinrichtung (7) derart ausgestaltet ist, dass das Abtastsignal (CLK) innerhalb des Oszillationszeitraums (t_{OSZ}) mehrere Zustandswechsel aufweist.

8. Vorrichtung (1) nach einem der Ansprüche 2 - 7, wobei das Zwischenspeicherelement (7) eine Flip-Flop-Einrichtung, insbesondere ein D-Flip-Flop, aufweist.

9. Vorrichtung (1) nach einem der Ansprüche 1 - 8, wobei die Vorrichtung (1) eine an den Eingangsknoten (3) gekoppelte Rechtecksignalerzeugungseinrichtung (6) aufweist, welche das Startsignal (ST) mit wechselnden logischen Pegeln erzeugt.

10. Vorrichtung (1) nach Anspruch 9, wobei die Rechtecksignalerzeugungseinrichtung (6) derart ausgestaltet ist, dass zu vorgegebenen Zeitpunkten ein logischer Pegelwechsel des Startsignals (ST) erfolgt.

11. Vorrichtung (1) nach einem der Ansprüche 1 - 10, wobei die Vorrichtung (1) eine Steuerungseinrichtung (5) aufweist, welche gemäß einer Programmierung ein Abgreifen eines Zufallsbitwertes an dem Ausgangsknoten (4) oder Zwischenspeicherelement (7) und/oder die Erzeugung des Startsignals (ST) veranlasst.

12. Vorrichtung (1) nach einem der Ansprüche 1 - 11, wobei der Ringoszillatorschaltkreis (2) in der Art eines Galois-Ringoszillators ausgeführt ist.

13. Vorrichtung (1) nach einem der Ansprüche 1 - 12, wobei der Ringoszillatorschaltkreis (2) in der Art eines Fibonacci-Ringoszillators ausgeführt ist.

14. Vorrichtung (1) nach einem der Ansprüche 1 - 13, wobei die Vorrichtung (1) als FPGA-Schaltung implementiert ist.

15. Zufallszahlengenerator mit einer Vorrichtung (1) nach einem der Ansprüche 1 - 14, wobei mehrere an dem Ausgangsknoten (4) abgegriffene Pegelwerte des Zufallssignals (OS) oder von einem Zwischenspeicherelement (7) gespeicherte logische Pegel (ZB) als Bitwerte einer Zufallszahl (ZZ) erfasst werden.

16. Verfahren zum Erzeugen einer Zufallsbitfolge, bei dem in Abhängigkeit von einem Pegelverlauf eines an einem digitalen Ringoszillatorschaltkreis (2) abgegriffenen Zufallssignals (OS) Zufallsbitwerte (ZB) bestimmt werden, **dadurch gekennzeichnet, dass** der digitale Ringoszillatorschaltkreis (2) eine ungerade Anzahl kaskadiert verschalteter Inverter (11-17) oder eine ungerade Anzahl kaskadiert verschalteter Logikschaltungen (21-27) aufweist, dass durch Aktivieren (S1) des Ringoszillatorschaltkreises (2) eine Oszillation erfolgt, wobei der Ringoszillatorschaltkreis (2) einen Fixpunkt aufweist, in dem die Inverter (11-17) oder die Logikschaltungen (21-27) logische Zustände aufweisen, die sich zeitlich nicht mehr ändern, und dass das Zufallssignal (OS) bis zum Erreichen des Fixpunkts mit einem zufälligen Pegelverlauf abgegriffen wird.

17. Verfahren nach Anspruch 16, wobei die folgenden Schritte durchgeführt werden:
- Aktivieren (S1) eines digitalen Ringoszillatorschaltkreises (2), der einen Fixpunkt aufweist; und
- Abgreifen (S2, S21) eines oder mehrerer Pegelwerte eines von dem Ringoszillatorschaltkreis (2) erzeugten oszillierenden Zufallssignals (OS).

18. Verfahren nach Anspruch 16 oder 17, wobei der Ringoszillatorschaltkreis (2) zum Erzeugen mehrerer Zufallsbitwerte mehrfach aktiviert wird.

19. Verfahren nach einem der Ansprüche 16 - 18, wobei in Abhängigkeit von dem Verlauf des Zufallssignals (OS) ein Zufallsbitwert bestimmt wird (S21, S22).

20. Verfahren nach einem der Ansprüche 16 - 19, wobei das Zufallssignal mehrfach abgetastet wird und in Abhängigkeit von einem jeweiligen Pegelwert des Zufallssignals (OS) ein logischer Pegel eines Zufallsbits verändert wird.

21. Verfahren nach einem der Ansprüche 16 - 20, wobei eine durchschnittliche Oszillationszeit (MOT) des Ringoszillatorschaltkreises (2) bestimmt wird.

22. Verfahren nach Anspruch 20, wobei innerhalb der minimalen durchschnittlichen Oszillationszeit (MOT) der Pegel des Zufallssignals (OS) mehrfach erfasst wird.

## Claims

1. Device (1) for generating a random bit sequence with a digital ring oscillator circuit (2) having logic components, having an input node (3) and an output node (4), the digital ring oscillator circuit (2) being embodied such that oscillation takes place when a logic start signal (ST) coupled to the input node (3) changes state, **characterised in that** said oscillation has a fixed point, in which the logic components have logic states which no longer change temporally, wherein the logic components have an uneven number of inverters (11-17) connected in a cascaded manner or an uneven number of logic circuits (21-27) connected in a cascaded manner, wherein it is possible to tap a random signal (OS) with a random level curve at the output node (4) in order to achieve the fixed point.

2. Device (1) according to claim 1, wherein the device (1) has a buffer element (7) coupled to the output node (4), which stores a logic level as a function of the random signal (OS).

3. Device (1) according to claim 2, wherein the buffer element (1) stores a logic level corresponding to the random signal (OS).

4. Device (1) according to claim 2 or 3, wherein the buffer element (7) stores a logic level corresponding to the random signal (OS) as a function of a sampling signal (CLK).

5. Device (1) according to claim 4, wherein the device (1) has a sampling signal generation facility (5), which generates a logic change of state of the sampling signal (CLK) at predetermined times.

6. Device (1) according to claim 4 or 5, wherein the sampling signal generation facility (7) is embodied such that the sampling signal (CLK) has a number of changes of state within a predetermined time period.

7. Device (1) according to one of claims 4 to 6, wherein the fixed point occurs after an oscillation period (t_{OSZ}) and the sampling signal generation facility (7) is embodied such that the sampling signal (CLK) has a number of changes of state within the oscillation period (tosz).

8. Device (1) according to one of claims 2 to 7, wherein the buffer element (7) has a flip flop facility, in particular a D flip flop.

9. Device (1) according to one of claims 1 to 8, wherein the device (1) has a rectangular signal generation facility (6) coupled to the input node (3), to generate the start signal (ST) with changing logic levels.

10. Device (1) according to claim 9, wherein the rectangular signal generation facility (6) is embodied such that a logic level change of the start signal (ST) takes place at predetermined times.

11. Device (1) according to one of claims 1 to 10, wherein the device (1) has a control facility (5), which prompts tapping of a random bit value at the output node (4) or buffer element (7) and/or the generation of the start signal (ST) according to programming.

12. Device (1) according to one of claims 1 to 11, wherein the ring oscillator circuit (2) is embodied in the manner of a Galois ring oscillator.

13. Device (1) according to one of claims 1 to 12, wherein the ring oscillator circuit (2) is embodied in the manner of a Fibonacci ring oscillator.

14. Device (1) according to one of claims 1 to 13, wherein the device (1) is implemented as an FPGA circuit.

15. Random number generator with a device (1) according to one of claims 1 to 14, wherein a number of level values of the random signal (OS) tapped at the output node (4) or logic levels (ZB) stored by a buffer element (7) are captured as bit values of a random number (ZZ).

16. Method for generating a random bit sequence, wherein random bit values (ZB) are determined as a function of a level curve of a random signal (OS) tapped at a digital ring oscillator circuit (2), **characterised in that** the digital ring oscillator circuit (2) has an uneven number of inverters (11-17) connected in a cascaded manner or an uneven number of logic circuits (21-27) connected in a cascaded manner, that by activation (S1) of the ring oscillator circuit (2) an oscillation takes place, wherein the ring oscillator circuit (2) has a fixed point, in which the inverter (11-17) or the logic circuits (21-27) have logic states, which no longer change temporally and that the random signal (OS) is tapped until the fixed point with a random level curve is reached.

17. Method according to claim 16, wherein the following steps are implemented:
- activation (S1) of a digital ring oscillator circuit (2), having a fixed point; and
- tapping (S2, S21) of one or more level values of an oscillating random signal (OS) generated by the ring oscillator circuit (2).

18. Method according to claim 16 or 17, wherein the ring oscillator circuit (2) is activated a number of times to generate a number of random bit values.

19. Method according to one of claims 16 to 18, wherein a random bit value is determined (S21, S22) as a function of the curve of the random signal (OS).

20. Method according to one of claims 16 to 19, wherein the random signal is sampled a number of times and a logic level of a random bit is changed as a function of a respective level value of the random signal (OS).

21. Method according to one of claims 16 to 20, wherein a mean oscillation time (MOT) of the ring oscillator circuit (2) is determined.

22. Method according to claim 20, wherein the level of the random signal (OS) is captured a number of times within the minimum mean oscillation time (MOT).

## Revendications

1. Dispositif (1) permettant de générer une séquence binaire aléatoire, comprenant un circuit de commutation numérique (2) à oscillateur annulaire présentant des composants logiques, lequel circuit de commutation présente un noeud d'entrée (3) et un noeud de sortie (4), le circuit de commutation numérique à oscillateur annulaire (2) étant réalisé de manière à ce que lors d'un changement d'état d'un signal de départ logique (ST) couplé au noeud d'entrée (3), il s'ensuive une oscillation, **caractérisé en ce que** celle-ci présente un point fixe dans lequel les composants logiques présentent des états logiques qui ne se modifient plus temporellement, les composants logiques présentant un nombre impair de circuits inverseurs (11 - 17) connectés de manière cascadée ou un nombre impair de circuits logiques (21 - 27) connectés de manière cascadée, un signal aléatoire (OS) pouvant être saisi avec une allure de niveau aléatoire sur le noeud de sortie (4) jusqu'à l'obtention du point fixe.

2. Dispositif (1) selon la revendication 1, le dispositif (1) présentant un élément de mémoire intermédiaire (7) couplé au noeud de sortie (4), lequel élément de mémoire intermédiaire mémorise un niveau logique en fonction du signal aléatoire (OS).

3. Dispositif (1) selon la revendication 2, l'élément de mémoire intermédiaire (7) mémorisant un niveau logique correspondant au signal aléatoire (OS).

4. Dispositif (1) selon la revendication 2 ou 3, l'élément de mémoire intermédiaire (7) mémorisant un niveau logique correspondant au signal aléatoire (OS) en fonction d'un signal d'échantillonnage (CLK).

5. Dispositif (1) selon la revendication 4, le dispositif (1) présentant un dispositif générateur de signaux d'échantillonnage (5), lequel génère un changement d'état logique du signal d'échantillonnage (CLK) à des moments prédéfinis.

6. Dispositif (1) selon la revendication 4 ou 5, le dispositif générateur de signaux d'échantillonnage (5) étant réalisé de manière à ce que le signal d'échantillonnage (CLK) présente plusieurs changements d'état pendant une période de temps prédéfinie.

7. Dispositif (1) selon l'une quelconque des revendications 4 à 6, le point fixe se produisant après une période d'oscillation (t_{osz}) et le dispositif générateur de signaux d'échantillonnage (7) étant réalisé de manière à ce que le signal d'échantillonnage (CLK) présente plusieurs changements d'état pendant la période d'oscillation (t_{osz}).

8. Dispositif (1) selon l'une quelconque des revendications 2 à 7, l'élément de mémoire intermédiaire (7) présentant un dispositif flip flop, notamment un flip flop de type D.

9. Dispositif (1) selon l'une quelconque des revendications 1 à 8, le dispositif (1) présentant un dispositif générateur de signaux rectangulaires (6) couplé au noeud d'entrée (3), lequel dispositif générateur de signaux rectangulaires génère le signal de départ (ST) avec des niveaux logiques changeants.

10. Dispositif (1) selon la revendication 9, le dispositif générateur de signaux rectangulaires (6) étant réalisé de manière à ce qu'un changement de niveau logique du signal de départ (ST) ait lieu à des moments prédéfinis.

11. Dispositif (1) selon l'une quelconque des revendications 1 à 10, le dispositif (1) présentant un dispositif de commande (5) lequel, selon une programmation, ordonne une saisie d'une valeur binaire aléatoire sur le noeud de sortie (4) ou sur l'élément de mémoire intermédiaire (7) et/ou la génération du signal de départ (ST).

12. Dispositif (1) selon l'une quelconque des revendications 1 à 11, le circuit de commutation à oscillateur annulaire (2) étant réalisé de manière semblable à un oscillateur annulaire de Galois.

13. Dispositif (1) selon l'une quelconque des revendications 1 à 12, le circuit de commutation à oscillateur annulaire (2) étant réalisé de manière semblable à un oscillateur annulaire de Fibonacci.

14. Dispositif (1) selon l'une quelconque des revendications 1 à 13, le dispositif (1) étant réalisé comme circuit FPGA.

15. Générateur de nombres aléatoires comprenant un dispositif (1) selon l'une quelconque des revendications 1 à 14, plusieurs valeurs de niveau du signal aléatoire (OS), saisies sur le noeud de sortie (4), ou les niveaux logiques (ZB) mémorisés par un élément de mémoire intermédiaire (7) étant saisis comme valeurs binaires d'un nombre aléatoire (ZZ).

16. Procédé permettant de générer une séquence binaire aléatoire, dans lequel des valeurs binaires aléatoires (ZB) sont déterminées en fonction d'une allure de niveau d'un signal aléatoire (OS) saisi sur un circuit de commutation numérique à oscillateur annulaire (2), **caractérisé en ce que** le circuit de commutation numérique à oscillateur annulaire (2) présente un nombre impair de circuits inverseurs (11 - 17) connectés de manière cascadée ou un nombre impair de circuits logiques (21 - 27) connectés de manière cascadée, **en ce qu'**une oscillation a lieu en raison de l'activation (S1) du circuit de commutation à oscillateur annulaire (2), le circuit de commutation à oscillateur annulaire (2) présentant un point fixe, dans lequel les circuits inverseurs (11 - 17) ou les circuits logiques (21 - 27) présentent des états logiques qui ne changent plus temporellement, et **en ce que** le signal aléatoire (OS) est saisi avec une allure de niveau aléatoire jusqu'à l'obtention du point fixe.

17. Procédé selon la revendication 16, les étapes suivantes étant exécutées :
- activation (S1) d'un circuit de commutation numérique à oscillateur annulaire (2), lequel présente un point fixe ; et
- saisie (S2, S21) d'une ou de plusieurs valeurs de niveau d'un signal aléatoire (OS) oscillant généré par le circuit de commutation à oscillateur annulaire (2).

18. Procédé selon la revendication 16 ou 17, le circuit de commutation à oscillateur annulaire (2) étant activé plusieurs fois pour générer plusieurs valeurs binaires aléatoires.

19. Procédé selon l'une quelconque des revendications 16 à 18, une valeur binaire aléatoire étant déterminée (S21, S22) en fonction de l'allure du signal aléatoire (OS).

20. Procédé selon l'une quelconque des revendications 16 à 19, le signal aléatoire étant échantillonné plusieurs fois et un niveau logique d'un bit aléatoire étant modifié en fonction d'une valeur de niveau respective du signal aléatoire (OS).

21. Procédé selon l'une quelconque des revendications 16 à 20, un temps d'oscillation moyen (MOT) du circuit de commutation à oscillateur annulaire (2) étant déterminé.

22. Procédé selon la revendication 20, le niveau du signal aléatoire (OS) étant saisi plusieurs fois pendant le temps d'oscillation moyen minimal.
